# EUROPEAN PATENT SPECIFICATION

(11) **EP 3 235 588 B1**
(45) Date of publication and mention of the grant of the patent: **06.11.2019**
(21) Application number: 15869874.6
(22) Date of filing: 09.12.2015
(51) Int. Cl.: B23K 35/26, C22C 13/00, C23C 30/00, C23C 2/04, C23C 2/08, H05K 1/11, B23K 101/36

(54) **SOLDER ALLOY FOR PLATING AND ELECTRONIC COMPONENT**
LÖTLEGIERUNG ZUR PLATTIERUNG UND ELEKTRONISCHES BAUTEIL
ALLIAGE DE SOUDURE DESTINÉ AU PLACAGE ET COMPOSANT ÉLECTRONIQUE

(30) Priority: 15.12.2014 JP 2014253286
(43) Date of publication of application: 25.10.2017
(73) Proprietor: Senju Metal Industry Co., Ltd, Tokyo 120-8555 (JP); DDK Ltd., Tokyo 1350042 (JP)
(72) Inventor: TSURUTA Kaichi, Tokyo 120-8555 (JP); MUNEKATA Osamu, Tokyo 120-8555 (JP); IWAMOTO Hiroyuki, Tokyo 120-8555 (JP); IKEDA Atsushi, Tokyo 120-8555 (JP); MORIUCHI Hiroyuki, Tokyo 135-0042 (JP); KAYAMA Shinichi, Tokyo 135-0042 (JP); TADOKORO Yoshihiro, Tokyo 135-0042 (JP)
(74) Representative: Zimmermann & Partner Patentanwälte mbB
(86) International application number: PCT/JP2015/084560
(87) International publication number: WO 2016/098669

(56) References cited:
- EP-A1- 1 932 952
- EP-A1- 2 759 622
- JP-A- H06 344 180
- JP-A- H11 193 494
- JP-A- H11 193 494
- JP-A- 2000 077 253
- JP-A- 2006 249 460
- JP-A- 2006 249 460
- JP-A- 2007 100 148
- JP-A- 2008 021 501
- JP-A- 2008 021 501
- JP-A- 2013 221 166
- JP-B2- 3 754 152
- US-A- 3 940 319
- US-A1- 2002 155 024
- Sergey Aleksandrovich Belyakov: "Microstructure formation and soldering in Sn-Ni alloys", Thesis or dissertation, 31 May 2013 (2013-05-31), XP055472183, Retrieved from the Internet: URL:https://spiral.imperial.ac.uk:8443/bit stream/10044/1/17998/1/Belyakov-SA-2013-Ph D-Thesis.pdf [retrieved on 2018-05-03]
- MEDVEDEV G I ET AL: "Electrodeposition of tin-cobalt alloy from a sulfate electrolyte with organic additives", RUSSIAN JOURNAL OF APPLIED CHEMISTRY, NAUKA/INTERPERIODICA, MO, vol. 85, no. 1, 17 February 2012 (2012-02-17), pages 52-56, XP035015689, ISSN: 1608-3296, DOI: 10.1134/S1070427212010107
- SINN-WEN CHEN ET AL: "Co Solubility in Sn and Interfacial Reactions in Sn-Co/Ni Couples", JOURNAL OF ELECTRONIC MATERIALS., vol. 39, no. 11, 14 August 2010 (2010-08-14), pages 2418-2428, XP055472232, US ISSN: 0361-5235, DOI: 10.1007/s11664-010-1337-7
- CHEN SINN-WEN ET AL: "Liquidus Projections of Sn-Co-Ni and Sn-Rich Sn-Ag-Co-Ni Systems", JOURNAL OF ELECTRONIC MATERIALS, WARRENDALE, PA, US, vol. 43, no. 7, 18 April 2014 (2014-04-18) , pages 2487-2497, XP035314239, ISSN: 0361-5235, DOI: 10.1007/S11664-014-3130-5 [retrieved on 2014-04-18]

## Description

### TECHNICAL FIELD

The present invention relates to use of a solder alloy for plating used for an electric contact that establishes electric continuity by mechanical joining, particularly to use a solder alloy for plating in a fitting type connection terminal.

### BACKGROUND ART

Conventionally, surfaces of wiring materials, particularly wiring materials made of copper or a copper alloy are plated with tin (Sn), silver (Ag), gold (Au) or nickel (Ni) in order to prevent the wiring materials from oxidizing. In particular, Sn is inexpensive, and owing to its softness, readily deforms when receiving pressure upon fitting (contacting), leading to an increased contact area and a lower contact resistance. Accordingly, wiring materials with Sn-plated surfaces are widely and typically used.

As alloys for such Sn plating, use of Pb-free materials and non-halogen materials has been recently required from an environmental viewpoint, and various materials used for wiring materials are also required to be Pb-free or halogen-free.

It is known that there is a problem in that, as Sn plating is made Pb-free, particularly in Sn- or Sn alloy-plating, whiskers that are needle-like crystals of Sn are generated from plating, which may cause a short circuit between adjacent wiring materials.

In connection with whiskering, it gradually becomes apparent that a portion (electric contact) to which an external stress is applied through mechanical joining (e.g., fitting, pressing, inserting and caulking) cannot avoid such whiskering even when the portion undergoes reflow treatment.

In this description, a whisker generated at an electric contact due to an external stress applied through mechanical joining is also called "external stress-type whisker."

As other types of whiskers generated due to different causes from those of generation of external stress-type whiskers, known are an "internal stress-type whisker (naturally-generated whisker)" generated due to volume expansion associated with the growth of an intermetallic compound in Sn plating, a "temperature cycle-type whisker" generated due to a compressive stress resulting from the difference in thermal expansion between a substrate and Sn plating, and an "oxidation/corrosion-type whisker" generated due to a compressive stress resulting from oxidation or corrosion of Sn in a high temperature and high humidity environment.

Patent Literature 1 describes, as a solder alloy capable of eliminating the problem associated with external stress-type whiskers, "a Pb-free solder alloy comprising: Ag of 0.1 to 5 wt%; Cu of 0.1 to 5 wt%; a first dopant of not more than 10 wt%, the first dopant comprising at least one element selected from a group consisted of Sb, Bi, Cd, In, Ag, Au, Ni, Ti, Zr, and Hf; a second dopant of not more than 10 wt%, and the second dopant comprising at least one element selected from a group consisted of Ge, Zn, P, K, Cr, Mn, Na, V, Si, Al, Li, Mg and Ca; and Sn as a remaining part" ([claim 10]).

Patent Literature 2 describes "a Pb-free solder alloy comprising: not less than 0.1 wt% but not more than 3.5 wt% of Ag; not less than 0.1 wt% but not more than 3.5 wt% of Cu; not less than 0.002 wt% but not more than 0.5 wt% of Zn; and the balance of Sn" and "the Pb-free solder alloy obtained by adding at least one of P, Ge, K, Cr, Mn, Na, V, Si, Ti, Al, Li, Mg, Ca and Zr as an oxidation control element" ([claim 10] and [claim 11]).

Patent Literature 3 discloses an electrical component for wiring used for a terminal-connection portion which consists of lead-free tin-type material portion having a crystal structure, and a transformation delay metal-plating film containing transformation delay elements.

### CITATION LIST

### PATENT LITERATURE

Patent Literature 1: JP 2008-031550 A
Patent Literature 2: JP 2011-192652 A
Patent Literature 3: JP 2008 021501 A

### SUMMARY OF INVENTION

### TECHNICAL PROBLEMS

The present inventors have made a study on the Pb-free solder alloys described in Patent Literatures 1 and 2 and found that some types and combinations of added metals do not serve to sufficiently suppress the generation of external stress-type whiskers.

An object of the present invention is therefore to provide the use of a solder alloy for plating that is capable of suppressing the generation of external stress-type whiskers.

### SOLUTION TO PROBLEMS

The present inventors have made an intensive study to achieve the object above and found that by adding a specific amount(s) of Ni in addition to Sn, the generation of external stress-type whiskers can be suppressed. The invention has been thus completed.

Accordingly, the present inventors found that the object can be achieved by the characteristic features as described below.
[1] The use of a solder alloy in a fitting type connection terminal, wherein
   the fitting type connection terminal comprises an electronic component;
   the electronic component comprises a metal substrate obtained by Ni-plating a surface of a metal substrate and a plating film that is formed of the solder alloy in a joint area of the metal substrate;
   the solder alloy is a solder alloy for plating for an electric contact that establishes electric continuity by mechanical joining,
   the solder alloy comprising Sn and Ni,
   wherein a Ni content is not less than 0.40 wt% but and not greater than 0.6 wt%, and
   a balance is Sn.

### ADVANTAGEOUS EFFECTS OF INVENTION

As described below, the present invention is able to provide the use of a solder alloy for plating that is capable of suppressing the generation of external stress-type whiskers.

### BRIEF DESCRIPTION OF DRAWINGS

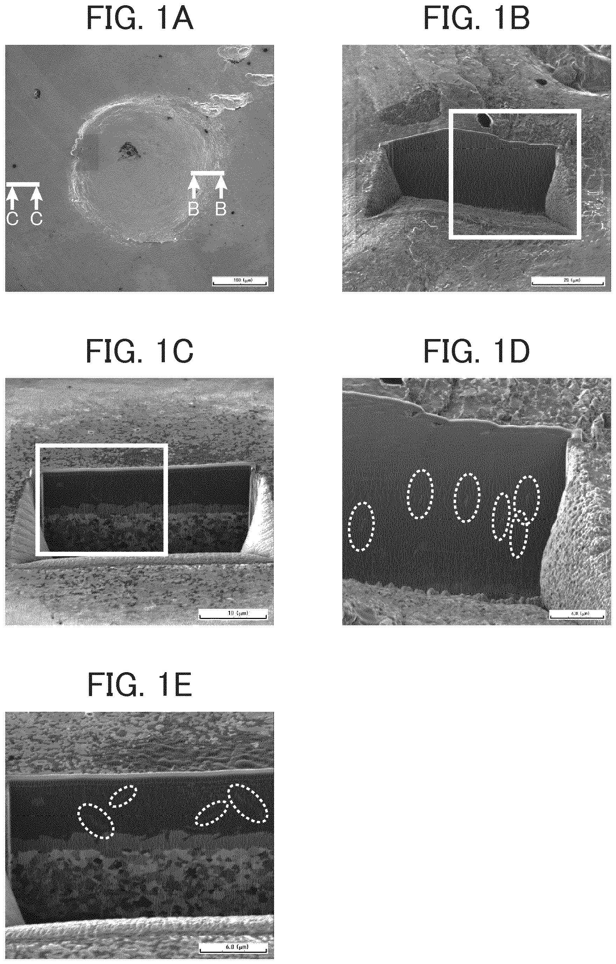

[FIG. 1] FIG. 1(A) is a scanning electron microscope (SEM) image of an indentation and its periphery of a plating film formed of a solder alloy (Sn-0.4Ni) prepared in Example 5; FIG. 1(B) is an SEM image of a cross section taken along the white line in FIG. 1(A) as observed in the direction of arrow B; FIG. 1(C) is an SEM image of a cross section taken along the other white line in FIG. 1(A) as observed in the direction of arrow C; FIG. 1(D) is an enlarged photograph of the region surrounded by the white line in FIG. 1(B); and FIG. 1(E) is an enlarged photograph of the region surrounded by the white line in FIG. 1(C).
[FIG. 2] FIG. 2(A) is a scanning electron microscope (SEM) image of an indentation and its periphery of a plating film formed of a solder alloy (Sn-0.3Co) prepared in Reference example 15; FIG. 2(B) is an SEM image of a cross section taken along the white line in FIG. 2(A) as observed in the direction of arrow B; FIG. 2(C) is an SEM image of a cross section taken along the other white line in FIG. 2(A) as observed in the direction of arrow C; and FIG. 2(D) is an enlarged photograph of the region surrounded by the white line in FIG. 2(B).
[FIG. 3] FIG. 3 is a graph showing the relationship between the Ni content and the zero cross time for a solder alloy containing Sn and Ni.
[FIG. 4] FIG. 4 is a graph showing the relationship between the Co content and the zero cross time for a solder alloy containing Sn and Co.
[FIG. 5] FIGS. 5(A) and 5(B) are graphs each showing a relationship between the Ni and Co content and the zero cross time for a solder alloy containing Sn, Ni and Co.

### DESCRIPTION OF EMBODIMENT AND EXAMPLE CONFIGURATIONS

The solder alloy for plating and the electronic component according to the invention, as well as example configurations useful for understanding the present invention, are described below.

In this description, any numerical range using "to" refers to a numerical range including the values stated before and after "to" as the upper and lower limits, and the sign "%" for the content refers to % by mass.

### [Solder Alloy for Plating]

In a first embodiment of the invention, a solder alloy is used for an electric contact that establishes electric continuity by mechanical joining, comprises Sn and Ni, wherein the Ni content is not less than 0.40 wt% but not greater than 0.6 wt%, and the balance is Sn.

A solder alloy for plating according to a second example configuration used for an electric contact that establishes electric continuity by mechanical joining, comprises Sn and Co, wherein the Co content is not less than 0.01 wt% but less than 8 wt%, and the balance is Sn.

A solder alloy for plating according to a third example configuration used for an electric contact that establishes electric continuity by mechanical joining, comprises Sn, Ni and Co, wherein the total content of Ni and Co is less than 9.5 wt%, the Ni content and the Co content are each greater than 0 wt% and at least one of the requirement that the Ni content is not less than 0.03 wt% and the requirement that the Co content is not less than 0.010 wt% is satisfied, and the balance is Sn.

When the solder alloy used according to the first embodiment of the invention (hereinafter collectively called "solder alloy of the invention") contains a specific amount of Ni in addition to Sn, the generation of external stress-type whiskers is suppressed.

Although not evident for details, the mechanism of this is assumed as below.

First, the present inventors assumed that external stress-type whiskers are generated because Sn atoms contained in a plating film are dispersed due to a mechanical stress applied from the outside and subsequently, the Sn atoms are recrystallized, resulting in the generation of whiskers, which are whisker-like crystals.

The present inventors then assumed that when a specific amount(s) of Ni and/or Co is contained in addition to Sn, a Sn-Ni compound, a Sn-Co compound or a Sn-Ni-Co compound is to be present in a plating film, which serves to inhibit the dispersion of Sn atoms, leading to a decrease in growth and even generation of whiskers.

This assumption can be made also from the results obtained from cross sections of plating films formed of solder alloys prepared in Examples to be described later.

In addition, the present inventors found that, with Sn plating using a solder alloy containing a specific small amount of Ni, the generation of internal stress-type whiskers mentioned above is unable to be suppressed. Considering this finding, it can be said that the fact that the solder alloy of the invention brings about the effect of suppressing the generation of external stress-type whiskers is totally unforeseeable.

Alloy compositions of the solder alloy of the invention and example configurations are described in detail below.

### <Ni (First Embodiment)>

In the first embodiment of the invention, the Ni content is not less than 0.40 wt% but not greater than 0.6 wt%.

Ni is an element that influences the suppression of generation of whiskers and the occurrence of fractures and cracks. With a Ni content of less than 0.06%, the effect of suppressing the generation of whiskers is not exhibited.

The Ni content is less than 5.0% for the sake of, inter alia, heat resistance of an electronic component in cases where a plating film is formed by hot dipping and appearance of a plating film in cases where the plating film is formed by electroplating.

In the present invention, the Ni content is not greater than 0.6% for the sake of wettability in cases where a plating film is formed by hot dipping, and is not less than 0.40% for the purpose of further suppressing the generation of whiskers.

### <Co (Second Example Configuration)>

In the second example configuration, the Co content is not less than 0.01% but less than 8%.

Co is an element that influences the suppression of generation of whiskers and the occurrence of fractures and cracks. With a Co content of less than 0.01%, the effect of suppressing the generation of whiskers is not exhibited, while with a Co content of not less than 8%, fractures or cracks should occur in a surface of a plating film by external stresses.

The Co content is preferably not greater than 0.4% for the sake of wettability in cases where a plating film is formed by hot dipping, and more preferably greater than 0.1% for the purpose of further suppressing the generation of whiskers.

### <Ni and Co (Third Example Configuration)>

In the third example configuration, the total content of Ni and Co is less than 9.5%.

In the third example configuration in which Ni and Co are contained, each of the Ni content and the Co content is greater than 0%, and at least one of the requirement that the Ni content is not less than 0.03% and the requirement that the Co content is not less than 0.010% is satisfied.

When the requirement that the Ni content is not less than 0.03% is satisfied, the Co content is preferably not greater than 0.4% for the sake of wettability in cases where a plating film is formed by hot dipping.

When the requirement that the Co content is not less than 0.010% is satisfied, the Ni content is preferably not greater than 0.6% for the sake of wettability in cases where a plating film is formed by hot dipping.

When the requirement that the Ni content is not less than 0.03% and the requirement that the Co content is not less than 0.010% are both satisfied, it is preferable that the Ni content be not greater than 0.6% and the Co content be not greater than 0.4% for the sake of wettability in cases where a plating film is formed by hot dipping.

The total content of Ni and Co is preferably not greater than 0.6% for the sake of wettability in cases where a plating film is formed by hot dipping, and more preferably greater than 0.1% for the purpose of further suppressing the generation of whiskers.

The use of the solder alloy of the invention can sufficiently suppress the generation of external stress-type whiskers and therefore can be suitably used as an electric contact that establishes electric continuity by mechanical joining, in a fitting type connection terminal.

Specifically, the use of the solder alloy of the invention is used preferably for a connector pin (metal terminal) of a connector and a terminal connecting portion (joint area) of a flexible flat cable (FFC) to be fitted with a connector.

An electronic component of the invention is described in detail below.

### [Electronic Component]

In the first embodiment of the invention, an electronic component comprises a metal substrate and a plating film formed in a joint area of the metal substrate, wherein the plating film contains Sn and Ni, the Ni content is not less than 0.40 wt% but not greater than 0.6 wt%, and the balance is Sn.

An electronic component according to a second example configuration comprises a metal substrate and a plating film formed in a joint area of the metal substrate, wherein the plating film contains Sn and Co, the Co content is not less than 0.01 wt% but less than 8 wt%, and the balance is Sn.

An electronic component according to a third example configuration comprises a metal substrate and a plating film formed in a joint area of the metal substrate, wherein the plating film contains Sn, Ni and Co, the total content of Ni and Co is less than 9.5 wt%, the Ni content and the Co content are each greater than 0 wt% and at least one of the requirement that the Ni content is not less than 0.03 wt% and the requirement that the Co content is not less than 0.010 wt% is satisfied, and the balance is Sn.

In the first embodiment of the invention , the electronic component (hereinafter called "electronic component of the invention") has a plating film containing, in addition to Sn, a specific amount of Ni as described above, thereby suppressing the generation of external stress-type whiskers at a surface of the plating film.

In this regard, the mechanism of suppression of generation of external stress-type whiskers should be the same as that described for the solder alloy of the invention as above and is therefore not described.

The configuration of the electronic component of the invention is described in detail below.

### <Metal Substrate>

A metal substrate included in the electronic component of the invention is not particularly limited, and preferred examples thereof include a metal substrate constituting a terminal connecting portion (joint area) of a flexible flat cable (FFC) mentioned above and a metal substrate constituting an electrode.

Specific examples of the metal substrate above include a Cu substrate, a Ni substrate and a Au substrate. A Cu substrate is preferably used and a substrate obtained by Ni-plating a surface of a Cu substrate, which serves as a core, is more preferably used because a plating film formed from the solder alloy of the invention can be easily formed.

The thickness of the metal substrate is not particularly limited, and is preferably 0.05 to 0.5 mm for the purpose of ensuring the strength of the electronic component and decreasing the thickness.

### <Plating Film>

A plating film included in the electronic component of the invention is a plating film that is formed in a joint area of the metal substrate and contains Sn and Ni as described below in detail.

### (Ni (First Embodiment))

In the first embodiment of the invention, the Ni content is not less than 0.40% and not greater than 0.6%.

Ni is an element that influences the suppression of generation of whiskers and the occurrence of fractures and cracks. With a Ni content of less than 0.06%, the effect of suppressing the generation of whiskers is not exhibited.

The Ni content is less than 5.0% for the sake of, inter alia, heat resistance of an electronic component in cases where a plating film is formed by hot dipping and appearance of a plating film in cases where the plating film is formed by electroplating.

In the present invention, the Ni content is not greater than 0.6% for the sake of wettability in cases where a plating film is formed by hot dipping, and is not less than 0.40% for the purpose of further suppressing the generation of whiskers.

### (Co (Second Example Configuration))

In the second example configuration, the Co content is not less than 0.01% but less than 8%.

Co is an element that influences the suppression of generation of whiskers and the occurrence of fractures and cracks. With a Co content of less than 0.01%, the effect of suppressing the generation of whiskers is not exhibited, while with a Co content of not less than 8%, fractures or cracks should occur in a surface of a plating film by external stresses.

In the second example configuration, the Co content is preferably not greater than 0.4% for the sake of wettability in cases where a plating film is formed by hot dipping, and more preferably greater than 0.1% for the purpose of further suppressing the generation of whiskers.

### (Ni and Co (Third Example Configuration))

In the third example configuration, the total content of Ni and Co is less than 9.5%.

In the third example configuration in which Ni and Co are contained, each of the Ni content and the Co content is greater than 0%, and at least one of the requirement that the Ni content is not less than 0.03% and the requirement that the Co content is not less than 0.010% is satisfied.

When the requirement that the Ni content is not less than 0.03% is satisfied, the Co content is preferably not greater than 0.4% for the sake of wettability in cases where a plating film is formed by hot dipping.

When the requirement that the Co content is not less than 0.010% is satisfied, the Ni content is preferably not greater than 0.6% for the sake of wettability in cases where a plating film is formed by hot dipping.

When the requirement that the Ni content is not less than 0.03% and the requirement that the Co content is not less than 0.010% are both satisfied, it is preferable that the Ni content be not greater than 0.6% and the Co content be not greater than 0.4% for the sake of wettability in cases where a plating film is formed by hot dipping.

The total content of Ni and Co is preferably not greater than 0.6% for the sake of wettability in cases where a plating film is formed by hot dipping, and more preferably greater than 0.1% for the purpose of further suppressing the generation of whiskers.

The method of forming a plating film (plating method) is not particularly limited, and exemplary methods include conventionally known plating methods such as hot dipping involving preparing the solder alloy of the invention and then melting the prepared solder alloy in, for instance, a jet solder bath to carry out plating, and electroplating involving carrying out plating with an electroplating device using one or more types of plating solutions such that the resultant plating film can have composition falling within the range defined above in the first embodiment.

The electronic component of the invention is capable of suppressing the generation of external stress-type whiskers not only when the plating film is formed from the solder alloy of the invention by hot dipping but also when the plating film is formed in the electronic component by electroplating such that the resultant plating film can have composition falling within the range defined above in the first embodiment.

The thickness of the plating film is not particularly limited, and is preferably 10 to 30 µm in the case of hot dipping and preferably 1 to 5 µm in the case of electroplating.

### EXAMPLES

The use of the solder alloy of the invention is described in detail below by way of examples and reference examples useful for understanding the invention. However, the present invention is not limited thereto.

### [Plating by Hot Dipping]

Using solder alloys having alloy composition shown in Tables 1 to 4 below, each Ni-plated Cu sheet (size: 30 mm x 30 mm x 0.3 mm; Ni-plating thickness: 3 µm) was subjected to hot dipping to form a plating film (thickness: 10 µm). After hot dipping, each sheet was rinsed with isopropyl alcohol (IPA) for 1 minute and subjected to ultrasonic cleaning with acetone for 5 minutes to remove flux residue.

A device used in hot dipping and plating conditions are as follows.

### <Device for Use>

Solder Checker SAT-5200 (manufactured by RHESCA Co., Ltd.)

### <Soldering Conditions>

- Immersion rate: 5 mm/s
- Immersion depth: 20 mm
- Immersion time: 7 seconds
- Solder bath temperature: 250°C to 400°C
- Flux for use: ES-1090 (manufactured by Senju Metal Industry Co., Ltd.)

### [Plating by Electoplating]

Each Ni-plated Cu sheet (size: 30 mm x 30 mm x 0.3 mm; Ni-plating thickness: 3 µm) was, along with a carbon sheet used as the anode, immersed in a beaker having therein a plating solution having been prepared to form a plating film having alloy composition shown in Tables 1 to 4, and current was applied to carry out electroplating, thereby forming a plating film (thickness: 5 µm).

Raw materials and the composition of the plating solution, the current density in plating, the bath temperature inside the beaker, and the time for which current was applied (plating time) were suitably adjusted for each of Reference examples, Examples and Comparative examples by conventionally known methods.

### <Maximum Whisker Length>

For each Ni-plated Cu sheet on which a plating film was formed, the length of an external stress-type whisker was measured by a ball indenter process according to "Whisker test methods for electronic connectors" defined in JEITA RC-5241. The measurement was performed at given three positions in each sample, and a whisker with the maximum length was measured. In plating films formed in Comparative examples 2, 5 to 8, 12 and 13, cracks occurred through the ball indenter process due to a large amount of Ni and/or Co present in the plating films and accordingly, the measurement of whisker length was not performed.

A device and conditions for the test and a device and conditions for measurement of whisker length are stated below.

As a result of the measurement, when the maximum whisker length was not greater than 30 µm, the generation of external stress-type whiskers was determined to have been suppressed and this was evaluated as "good." When the maximum whisker length was greater than 30 µm, the generation of external stress-type whiskers was determined not to have been suppressed and this was evaluated as "poor."

The measurements of maximum whisker lengths and the evaluation results are shown in Tables 1 to 4 below.

### (Tester)

A load tester that satisfies the specifications defined in "4.4 Load tester" of JEITA RC-5241 (Diameter of a zirconia ball indenter: 1 mm)

### (Test conditions)

- Load: 300 g
- Test period: 10 days (240 hours)

### (Device and conditions for measurement)

- FE-SEM: Quanta FEG250 (manufactured by FEI)
- Acceleration voltage: 10 kV

Of samples subjected to the whisker test through the ball indenter process, a sample having a plating film formed of a solder alloy (Sn-0.4Ni) prepared in Example 5 was cut by means of a focused ion beam (FIB) to obtain cross sections at an indentation and its periphery. An image of a surface of the plating film at the area including the indentation and its periphery and images of cross sections obtained at the indentation and its periphery, as taken with an SMI3050SE scanning electron microscope (SEM) (manufactured by Hitachi High-Tech Science Corporation), are shown in FIG. 1.

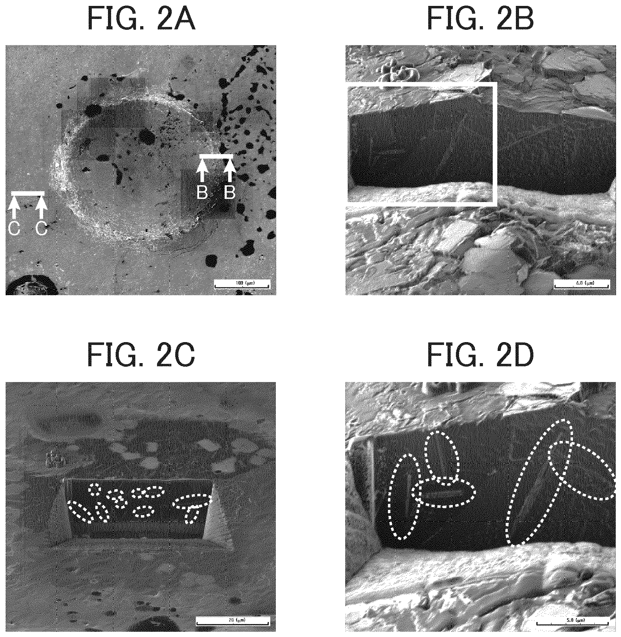

Similarly, an image of a surface of a plating film formed of a solder alloy (Sn-0.3Co) prepared in Example 15 at the area including an indentation and its periphery and images of cross sections obtained at the indentation and its periphery, as taken with a scanning electron microscope (SEM), are shown in FIG. 2.

As can be seen from the cross sections of the plating films shown in FIGS. 1 and 2, needle-like crystals (surrounded by broken lines) can be observed inside the plating films. As a result of analyses of these crystals using energy dispersive X-ray spectrometry (EDS), Sn and Ni were detected from the plating film (Sn-0.4Ni), and Sn and Co were detected from the plating film (Sn-0.3Co).

In this description, a solder alloy with a maximum whisker length of not greater than 30 µm is classified as an Example, while a solder alloy with a maximum whisker length of greater than 30 µm and a solder alloy with a maximum whisker length of not greater than 30 µm but allowing cracks to occur in the resultant plating are classified as Comparative example.

**[Table 1]**

| Table 1 | Alloy composition (% by weight) | | Type of plating | Maximum whisker | |
|---|---|---|---|---|---|
| | Sn | Pb | | Length (nm) | Evaluation |
| Reference example A | 100 | | Hot dipping | 36 | Poor |
| Reference example B | Balance | 10 | | 15 | Good |
| Reference example C | 100 | | Electroplating | 56 | Poor |

**[Table 2]**

| Table 2 | Alloy composition (% by weight) | | Type of plating | Maximum whisker | |
|---|---|---|---|---|---|
| | Sn | Ni | | Length (nm) | Evaluation |
| Comparative example 1 | Balance | 0,05 | Hot dipping | 47 | Poor |
| Reference example 1 | Balance | 0,06 | | 23 | Good |
| Reference example 2 | Balance | 0,07 | | 23 | Good |
| Reference example 3 | Balance | 0,10 | | 27 | Good |
| Reference example 4 | Balance | 0,30 | | 20 | Good |
| Example 5 | Balance | 0,40 | | 10 | Good |
| Example 6 | Balance | 0,50 | Electroplating | 8 | Good |
| Reference example 7 | Balance | 1,00 | | 17 | Good |
| Reference example 8 | Balance | 3,00 | | 11 | Good |
| Reference example 9 | Balance | 4,00 | | 14 | Good |
| Reference example 10 | Balance | 5,00 | | 7 | Good |
| Comparative example 2 | Balance | 10,00 | | - | - |

**[Table 3]**

| Table 3 | Alloy composition (% by weight) | | Type of plating | Maximum whisker | |
|---|---|---|---|---|---|
| | Sn | Co | | Length (nm) | Evaluation |
| Comparative example 3 | Balance | 0,005 | Hot dipping | 36 | Poor |
| Comparative example 4 | Balance | 0,007 | | 36 | Poor |
| Reference example 11 | Balance | 0,01 | | 20 | Good |
| Reference example 12 | Balance | 0,03 | | 19 | Good |
| Reference example 13 | Balance | 0,10 | | 13 | Good |
| Reference example 14 | Balance | 0,10 | Electroplating | 19 | Good |
| Reference example 15 | Balance | 0,30 | Hot dipping | 10 | Good |
| Reference example 16 | Balance | 1,00 | Electroplating | 16 | Good |
| Reference example 17 | Balance | 3,00 | | 10 | Good |
| Reference example 18 | Balance | 5,00 | | 5 | Good |
| Reference example 19 | Balance | 7,00 | | 3 | Good |
| Comparative example 5 | Balance | 8,00 | | - | - |
| Comparative example 6 | Balance | 9,90 | | - | - |
| Comparative example 7 | Balance | 10,00 | | - | - |
| Comparative example 8 | Balance | 26,00 | | - | - |

**[Table 4]**

| Table 4 | Alloy composition (% by weight) | | | Type of plating | Maximum whisker | | Total content of Ni+Co |
|---|---|---|---|---|---|---|---|
| | Sn | Ni | Co | | Length (nm) | Evaluation | |
| Comparative example 9 | Balance | 0,02 | 0,005 | Hot dipping | 39 | Poor | 0,025 |
| Comparative example 10 | Balance | 0,002 | 0,008 | | 35 | Poor | 0,01 |
| Comparative example 11 | Balance | 0,003 | 0,007 | | 35 | Poor | 0,01 |
| Reference example 20 | Balance | 0,01 | 0,01 | | 21 | Good | 0,02 |
| Reference example 21 | Balance | 0,005 | 0,02 | | 12 | Good | 0,025 |
| Reference example 22 | Balance | 0,03 | 0,005 | | 16 | Good | 0,035 |
| Reference example 23 | Balance | 0,04 | 0,005 | | 20 | Good | 0,045 |
| Reference example 24 | Balance | 0,005 | 0,04 | | 14 | Good | 0,045 |
| Reference example 25 | Balance | 0,30 | 0,90 | Electroplating | 26 | Good | 1,2 |
| Reference example 26 | Balance | 1,50 | 0,70 | | 14 | Good | 2,2 |
| Reference example 27 | Balance | 1,10 | 1,80 | | 11 | Good | 2,9 |
| Reference example 28 | Balance | 2,70 | 1,10 | | 7 | Good | 3,8 |
| Reference example 29 | Balance | 4,00 | 3,40 | | 12 | Good | 7,4 |
| Comparative example 12 | Balance | 5,20 | 4,30 | | - | - | 9,5 |
| Comparative example 13 | Balance | 3,70 | 5,80 | | - | - | 9,5 |

The results shown in Tables 1 to 4 revealed that an alloy containing a small amount of Ni or Co suppressed the maximum whisker length less than the alloys prepared in Reference examples A and B (Comparative examples 1, 3 and 4) .

It was also revealed that an alloy containing Ni and Co in which the amount of Ni or Co was small suppressed the maximum whisker length less than the alloys prepared in Reference examples A and B (Comparative examples 9 to 11).

Aside from that, the result of Reference example C revealed that an alloy free from Ni and Co did not suppress the maximum whisker length even through electroplating.

Further, it was revealed that an alloy containing a large amount(s) of Ni and/or Co suppressed the generation of whiskers but a crack occurred in a plating film along an indentation. Thus, the alloy is not suitable for use in fitting application (Comparative examples 2, 5 to 8, 12 and 13) .

In contrast, it was revealed that with an alloy in which the Ni content, the Co content or the total content of Ni and Co (when both were contained) was within the relevant specified range, the maximum whisker length was suppressed better than the alloy prepared in Reference examples A (Reference examples 1 to 4, Example 5, Reference examples 11 to 13, 15 and 20 to 24). This result was observed similarly in cases where a plating film was formed by electroplating (Example 6 and Reference Examples 7 to 10, 14, 16 to 19 and 25 to 29).

In particular, it was revealed from the comparison of Reference examples 1 to 4 and Example 5 that when the Ni content was greater than 0.30 wt%, the maximum whisker length was 10 µm, and the generation of whiskers was suppressed better than the case of using the Sn-Pb alloy (Reference example B) that had been conventionally recognized as having a good whiskering resistance.

Likewise, it was revealed from the comparison of Reference examples 11 to 15 that when the Co content was greater than 0.10 wt%, the maximum whisker length was 10 µm, and the generation of whiskers was suppressed better than the case of using the Sn-Pb alloy (Reference example B) that had been conventionally recognized as having a good whiskering resistance.

When the metal substrate on which a plating film is formed is changed to a "Cu sheet without Ni-plating," the same tendencies as those of Reference examples 1 to 4, Examples 5 and 6, and Reference examples 7 to 29 were seen.

### <Wettability>

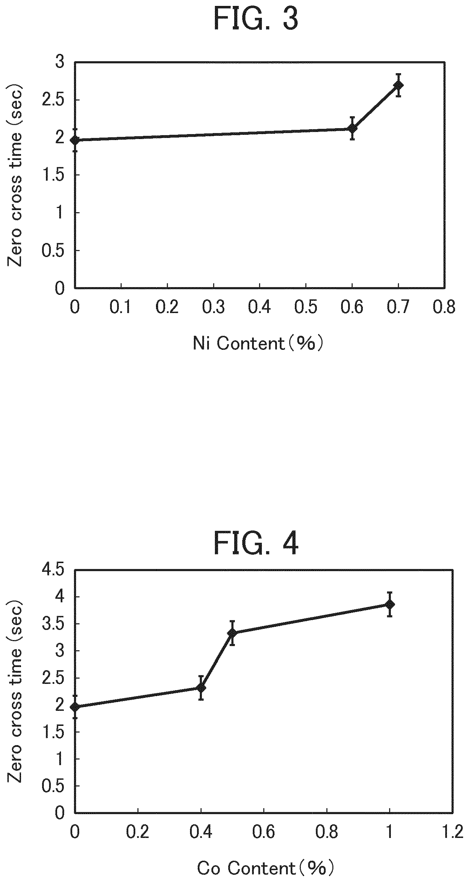

For each solder alloy containing, in addition to Sn, Ni and/or Co, the zero cross time was measured by a wetting balance method according to JIS Z 3198-4. The results are shown in FIGS. 3 to 5.

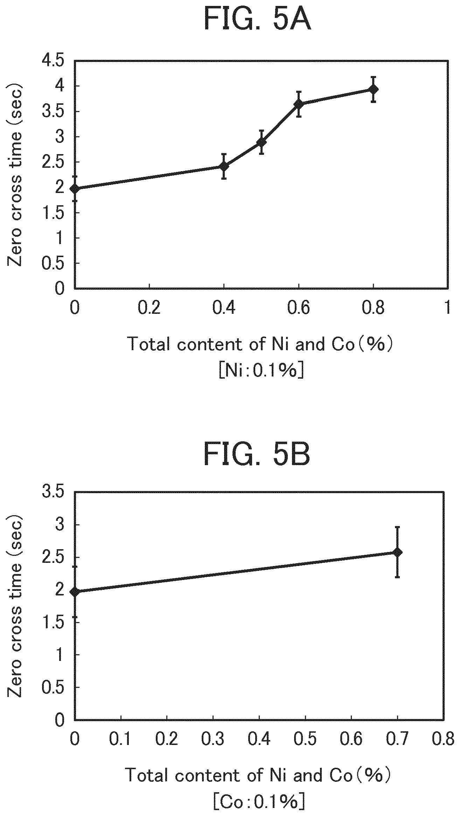

The result shown in FIG. 3 revealed that when the Ni content was not greater than 0.6%, the zero cross time was short and thus, wettability was good. Likewise, the result shown in FIG. 4 revealed that when the Co content was not greater than 0.4%, the zero cross time was short and thus, wettability was good. In addition, the results shown in FIG. 5 revealed that also when Ni and Co were contained, if the Ni content was not greater than 0.6% or the Co content was not greater than 0.4%, wettability was good.

A tester and test conditions used in the evaluation are as follows.

### (Tester)

Solder Checker SAT-5200 (manufactured by RHESCA Co., Ltd.)

### (Test conditions)

- Immersion rate: 10 mm/s
- Immersion depth: 2 mm
- Immersion time: 5 seconds
- Solder bath temperature: 250°C
- Flux for use: ES-1090 (manufactured by Senju Metal Industry Co., Ltd.)
- Cu sheet for use: 30 mm x 3 mm

## Claims

1. The use of a solder alloy in a fitting type connection terminal, wherein
the fitting type connection terminal comprises an electronic component;
the electronic component comprises a metal substrate obtained by Ni-plating a surface of a metal substrate and a plating film that is formed of the solder alloy in a joint area of the metal substrate;
the solder alloy is a solder alloy for plating for an electric contact that establishes electric continuity by mechanical joining,
the solder alloy comprising Sn and Ni,
wherein a Ni content is not less than 0.40 wt% and not greater than 0.6 wt%, and
a balance is Sn.

## Patentansprüche

1. Verwendung einer Lötlegierung in einem Armaturenverbindungsanschluss, wobei
der Armaturenverbindungsanschluss ein elektronisches Bauteil umfasst;
das elektronische Bauteil ein Metallsubstrat, das erhalten wird, indem eine Oberfläche eines Metallsubstrats Ni-plattiert wird, und einen Plattierungsfilm umfasst, der aus der Lötlegierung in einem Verbindungsstellenbereich des Metallsubstrats ausgebildet ist;
es sich bei der Lötlegierung um eine Lötlegierung zum Plattieren für einen elektrischen Kontakt handelt, der eine elektrische Durchgängigkeit durch mechanisches Verbinden herstellt,
die Lötlegierung Sn und Ni umfasst,
wobei ein Ni-Gehalt nicht weniger als 0,40 Gew.-% und nicht mehr als 0,6 Gew.-% beträgt, und
es sich bei einem Rest um Sn handelt.

## Revendications

1. Utilisation d'un alliage de soudage dans une borne de connexion du type enfichable, dans laquelle
la borne de connexion du type à raccordement comprend un composant électronique ;
le composant électronique comprend un substrat en métal obtenu par placage au Ni d'une surface d'un substrat en métal et un film de placage qui est formé de l'alliage de soudage dans une zone d'assemblage du substrat en métal ;
l'alliage de soudage est un alliage de soudage pour placage pour un contact électrique qui établit une continuité électrique par liaison mécanique,
l'alliage de soudage comprenant Sn et Ni,
dans laquelle une teneur en Ni n'est pas inférieure à 0,40 % en poids et pas supérieure à 0,6 % en poids, et un reste est Sn.
